# DEMANDE DE BREVET EUROPEEN

(11) **EP 4 345 577 A1**
(43) Date de publication de la demande: **03.04.2024**
(21) Numéro de dépôt: 22306439.5
(22) Date de dépôt: 28.09.2022
(51) Int. Cl.: G06F 1/20, H05K 7/20

(54) **DISSIPATEUR THERMIQUE POUR CARTE RÉSEAU DE LAME DE CALCUL**

(71) Demandeur: BULL SAS, 78340 Les Clayes-Sous-Bois (FR)
(72) Inventeur: LAMY, Pierre, 75014 PARIS (FR); MAGNOUX, Sébastien, 95540 MERY SUR OISE (FR)
(74) Mandataire: Argyma

(57) **Abrégé**

Dissipateur thermique (20) pour une carte réseau (10) de lame de calcul, ladite lame de calcul comprenant une plaque froide dans laquelle circule un liquide réfrigérant, ledit dissipateur thermique (20) comprenant un corps (210) comportant deux faces principales dont une face dite « chaude » (210C) et une face dite « froide » (210F), opposée à ladite face chaude (210C), ladite face froide (210F) étant configurée pour être interfacée avec la plaque froide, la face chaude (210C) comprenant au moins un logement (210C-1) configuré pour recevoir au moins un composant (110A, 110B) générateur de chaleur de la carte réseau (10).

## Description

### [Domaine technique]

La présente invention se rapporte au domaine du refroidissement des cartes réseaux d'une lame de calcul de supercalculateur et concerne plus particulièrement un dissipateur thermique pour carte réseau de lame de calcul et un module de dissipation thermique à refroidissement par conduction pour lame de calcul ainsi que leurs procédés de fabrication.

### [Etat de la technique antérieure]

Dans les lames de calcul pour serveur, notamment pour supercalculateur, il est connu d'utiliser des cartes réseaux haute vitesse, notamment de type mezzanine pour liens hautes vitesse, appelées cartes OCP 3.0, pour permettre la communication entre les lames de calcul et l'utilisation de la puissance de plusieurs processeurs pour l'exécution d'une même tâche.

Les solutions actuelles de refroidissement pour ces cartes OCP 3.0 utilisent le principe du refroidissement à air. En d'autres termes, les composants sont refroidis par des radiateurs à air interfacés sur la carte réseau.

Les cartes réseaux existantes présentent l'inconvénient de ne pas être compatibles avec des systèmes de refroidissement liquide sans convection forcée, dans lesquels le liquide de refroidissement circule dans une plaque froide.

En effet, chaque carte réseau ne comporte pas ses composants et ses connecteurs aux mêmes endroits ce qui rend complexe, voire impossible dans certains cas, un interfaçage direct de la carte réseau sur une plaque froide sans avoir à l'usiner. Ainsi, la plaque froide devrait donc être changée dès qu'un composant ou un connecteur est ajouté ou de dimensions différentes sur la carte réseau.

Il s'avérerait donc avantageux de proposer une solution simple, fiable et efficace permettant de remédier au moins en partie à ces inconvénients.

### [Exposé de l'invention]

L'un des buts de l'invention est de proposer une solution simple, fiable et efficace de dissipation thermique pour cartes réseaux, notamment de cartes OCP 3.0.

A cette fin, l'invention a pour objet un dissipateur thermique pour une carte réseau de lame de calcul, ladite lame de calcul comprenant une plaque froide dans laquelle circule un liquide réfrigérant, ledit dissipateur thermique comprenant un corps comportant deux faces principales dont une face dite « chaude » et une face dite « froide », opposée à ladite face chaude, ladite face froide étant configurée pour être interfacée avec la plaque froide, la face chaude comprenant au moins un logement configuré pour recevoir au moins un composant générateur de chaleur de la carte réseau.

Par le terme « interfacée », on entend que la face froide est conformée pour venir au contact de la plaque froide, de préférence sur toute la surface de ladite face froide, afin de lui transmettre efficacement sa chaleur. Le ou les composants générateurs de chaleur peuvent être des composants électroniques, par exemple de type puce ou microprocesseur ou condensateur, ou bien des composants électriques, par exemple de type connecteur.

En permettant à la carte réseau d'épouser sa forme, le dissipateur thermique selon l'invention présente une compacité améliorée permettant de minimiser l'espace occupé dans la lame de calcul. En outre, le dissipateur thermique selon l'invention peut être adapté à tout type de carte réseau, notamment pour le montage d'une carte au format OCP 3.0, en étant déclinable aux différents sous-formats SFF, TSFF, LFF de la norme OCP 3.0. En outre, le dissipateur thermique selon l'invention est compatible pour des lames de calcul sans circulation d'air forcé, notamment pour des lames de calcul à refroidissement liquide. En particulier, le dissipateur thermique selon l'invention est compatible avec la plupart des types existants de plaque froide.

De préférence, le dissipateur thermique comprend une interface de conduction de chaleur montée sur la face froide du corps afin d'améliorer la collecte de la chaleur générée par les composants de la carte réseau et le transfert de ladite chaleur par le corps, par conduction, vers la plaque froide.

Avantageusement, l'interface de conduction de chaleur se présente sous la forme d'une plaque conductrice de chaleur, de préférence réalisée en un matériau souple conducteur de chaleur tel que, par exemple, une pâte thermique conductrice ou une mousse thermique conductrice, notamment à mémoire de forme.

De manière préférée, le dissipateur thermique comprend un élément de boîtier destiné à recouvrir la carte réseau pour la protéger.

Dans une forme de réalisation, l'élément de boîtier comprend une plaque de protection configurée pour recouvrir au moins en partie la carte réseau, de préférence au moins sur 90 % de sa surface.

De préférence, la plaque de protection est réalisée en acier pour sa résistance et sa solidité.

De manière avantageuse, l'élément de boîtier comprend une façade de connexion, fixée à la plaque de protection, comprenant une portion s'étendant orthogonalement à la plaque de protection et délimitant au moins un orifice de réception d'un connecteur de la carte réseau afin de faciliter le montage et la connexion de la carte réseau dans la lame de calcul.

Selon un aspect de l'invention, le corps délimite, au niveau de la face froide, une pluralité d'attaches configurées chacune pour recevoir une vis permettant de fixer le corps sur la plaque froide.

Selon un autre aspect de l'invention, le corps délimite une pluralité d'orifices de fixation traversants, reliant la face chaude à la face froide, configurés chacun pour recevoir une vis d'assemblage permettant de solidariser à la fois le corps et la carte réseau.

L'utilisation de deux ensembles différents d'orifices de fixation pour fixer la carte réseau sur le corps et pour fixer le corps sur la plaque froide permet de monter la carte réseau sur le corps indépendamment du montage du dissipateur thermique sur la plaque froide.

Dans une forme de réalisation, le dissipateur thermique comprenant un élément de boîtier, ledit élément de boîtier délimite une pluralité d'orifices de fixation traversants, alignés avec les d'orifices de fixation traversants du corps, configurés chacun pour recevoir une vis d'assemblage permettant de solidariser à la fois l'élément de boîtier, le corps et la carte réseau.

De manière avantageuse, le corps est réalisé en métal, de préférence en aluminium, de préférence encore en aluminium série (ou grade) 6063 afin d'assurer les performances de refroidissement nécessaires.

L'invention concerne également un module de dissipation thermique comprenant une carte réseau montée sur le corps d'un dissipateur thermique tel que présenté précédemment.

Le module de dissipation thermique selon l'invention présente une compacité améliorée permettant de minimiser l'espace occupé dans la lame de calcul et est compatible avec la plupart des types existants de plaque froide.

La carte réseau est une carte électronique configurée pour permettre la communication entre la carte mère de la lame de calcul et au moins une autre lame de calcul ou un serveur afin notamment de permettre l'utilisation de la puissance de plusieurs processeurs pour l'exécution d'une même tâche.

De préférence, la carte réseau est de type OCP 3.0.

Le module de dissipation thermique comportant la carte réseau montée sur le corps, il peut être assemblé, de préférence à la chaîne, indépendamment dans un premier temps, avant d'être monté sur la plaque froide dans un second temps.

Dans une forme de réalisation, le dissipateur thermique comprenant un élément de boîtier de la carte réseau sur le corps, ledit élément de boîtier est solidaire au moins de la carte réseau, de préférence à la fois de la carte réseau et du corps, la carte réseau est montée entre l'élément de boîtier et le corps. L'élément de boîtier permet de protéger le côté de la carte réseau qui est opposé au côté en regard de la face chaude du corps du dissipateur thermique.

Dans une forme de réalisation, l'élément de boîtier est fixé au moyen de vis, de préférence au moyen de vis d'assemblage en deux parties qui sont efficaces pour solidariser des éléments, notamment de types plaques métalliques, entre eux.

L'invention concerne également une lame de calcul pour supercalculateur, ladite lame de calcul comprenant une plaque froide, à travers laquelle chemine un circuit de refroidissement liquide, et un module de dissipation thermique tel que présenté ci-avant dont le corps du dissipateur thermique est fixé sur la plaque froide par l'intermédiaire de sa face froide.

L'invention concerne également un procédé de fabrication d'un dissipateur thermique pour une carte réseau de lame de calcul, ledit procédé comprenant la création, de préférence par usinage, d'un corps comportant une face dite « chaude » et une face dite « froide », opposée à ladite face chaude, ladite face froide étant configurée pour être interfacée avec la plaque froide, la face chaude comprenant au moins un logement configuré pour recevoir au moins un composant générateur de chaleur de la carte réseau.

Dans un mode de réalisation, le procédé comprend en outre la création d'un élément de boîtier configuré pour être fixé sur le corps afin de protéger la carte réseau disposée entre ledit élément de boîtier et ledit corps.

L'invention concerne également un procédé d'assemblage d'un module de dissipation thermique, ledit procédé comprenant le montage d'une carte réseau sur le corps d'un dissipateur thermique tel que présenté ci-avant, la carte réseau comprenant une face supérieure comportant au moins un composant générateur de chaleur et une face inférieure, opposée à ladite face supérieure, le montage étant réalisé de sorte que la face supérieure de la carte réseau soit montée en regard de la face chaude du corps du dissipateur thermique, l'au moins un composant s'étendant dans l'au moins un logement de la face chaude.

Dans un mode de réalisation, le montage comprend la solidarisation de la carte réseau sur le corps au moyen de vis de fixation.

Dans un mode de réalisation, le procédé comprend le placement d'un élément de boîtier sur la carte réseau de sorte à protéger la face inférieure de la carte réseau.

De préférence, le montage comprend la solidarisation de l'élément de boîtier, de la carte réseau et du corps au moyen de vis de fixation. En variante, l'élément de boîtier pourrait être fixé uniquement sur la face inférieure de la carte réseau.

L'invention concerne également un procédé d'assemblage d'une lame de calcul, telle que décrite ci-avant, pour supercalculateur, ledit procédé comprenant la fixation d'un module de dissipation thermique tel que décrit ci-avant sur la plaque froide de la lame de calcul.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement une forme de réalisation d'un module de dissipation thermique selon l'invention en vue éclatée de dessus.
[Fig 2] La figure 2 illustre schématiquement le module de dissipation thermique de la figure 1 en vue assemblée.
[Fig 3] La figure 3 illustre schématiquement le module de dissipation thermique de la figure 1 en vue éclatée de dessous.
[Fig 4] La figure 4 illustre schématiquement le module de dissipation thermique de la figure 3 en vue assemblée.
[Fig 5] La figure 5 illustre schématiquement un mode de réalisation du procédé de fabrication selon l'invention.

### [Description des modes de réalisation]

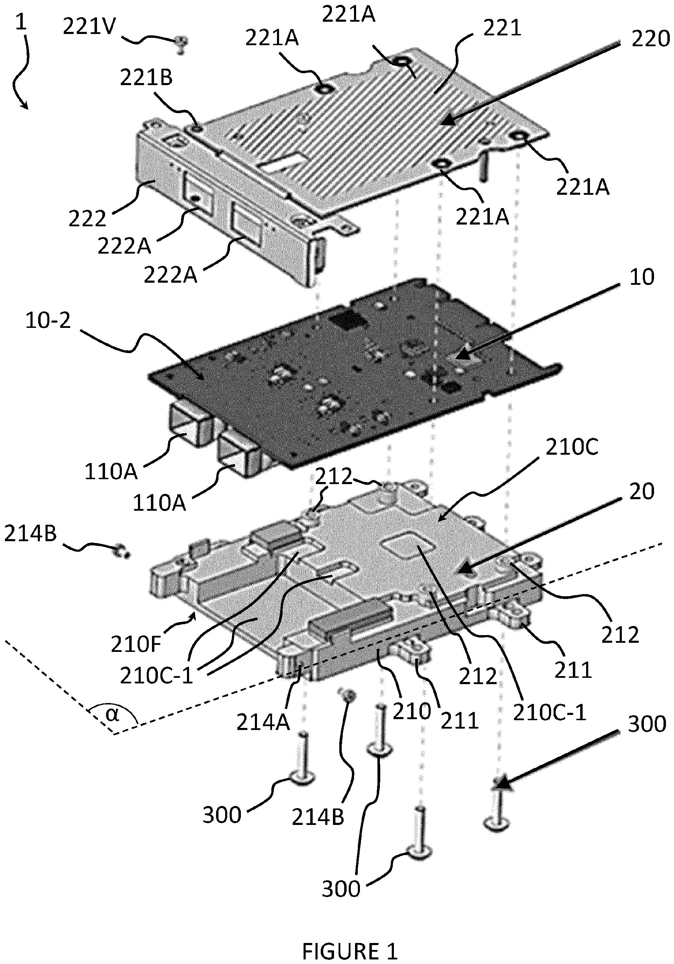

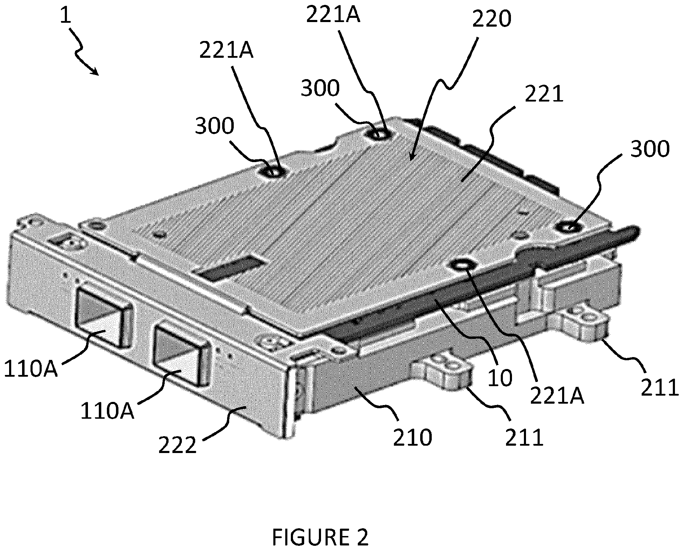

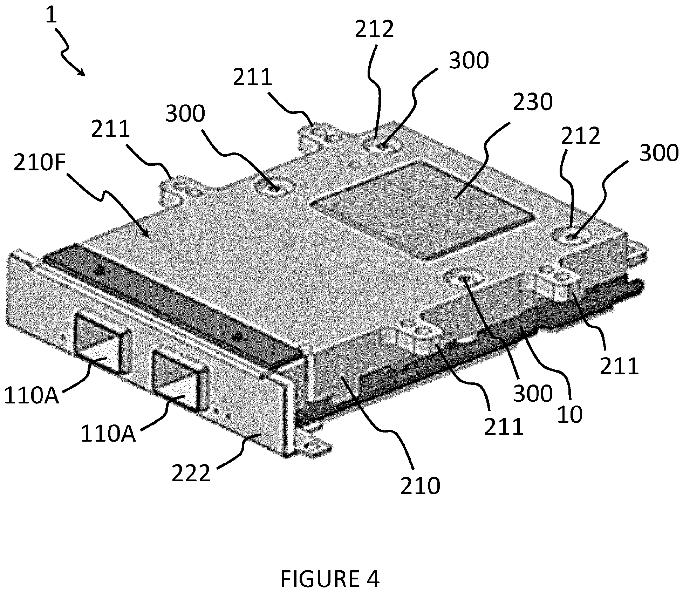

Les figures 1 à 4 illustrent différentes vues d'un exemple de module de dissipation thermique 1 selon l'invention (vues éclatées et assemblées de dessus et de dessous).

Le module de dissipation thermique 1 selon l'invention est destiné à être monté sur une plaque froide d'une lame de calcul de supercalculateur (non représentés).

### Lame de calcul

La lame de calcul est destinée à être montée dans une baie informatique d'un supercalculateur.

La lame de calcul comprend une carte mère configurée pour réaliser le traitement informatique de tâches, notamment des tâches de calcul et des tâches de communication avec d'autres lames de calcul ou des serveurs via un ou plusieurs réseaux de communication. A cette fin, la lame de calcul comprend une ou plusieurs cartes réseaux fournies dans autant de modules de dissipation thermique selon l'invention.

La lame de calcul comprend également une plaque froide à travers laquelle chemine un circuit de refroidissement liquide. Le circuit de refroidissement liquide permet d'acheminer du liquide réfrigérant, par exemple de l'eau, à travers la plaque froide afin de refroidir divers composants de la lame de calcul tels que, par exemple, le ou les processeurs de la carte mère ou les composants générateurs de chaleur de la ou des cartes réseaux, par l'intermédiaire de dissipateurs thermiques.

La plaque froide comprend notamment une surface adaptée pour recevoir un module de dissipation thermique 1 selon l'invention, de préférence une surface plane pour améliorer la conduction thermique entre ledit module de dissipation thermique 1 et ladite plaque froide.

### Module de dissipation thermique 1

Chaque module de dissipation thermique 1 comprend une carte réseau 10 et un dissipateur thermique 20 selon l'invention.

Le module de dissipation thermique 1 est destiné à être monté sur la plaque froide de la lame de calcul afin de refroidir la carte réseau 10 en collectant la chaleur générée par les composants électriques 110A ou électroniques 110B de ladite carte réseau 10.

### Carte réseau 10

La carte réseau 10 est configurée pour permettre la communication entre la carte mère de la lame de calcul dans laquelle elle est montée et une ou plusieurs autres lames de calcul ou serveurs, notamment pour permettre l'utilisation de la puissance de plusieurs processeurs pour l'exécution d'une même tâche.

Chaque carte réseau 10 comprend des composants électriques 110A et/ou des composants électroniques 110B, ces composants 110A, 110B générant ou pouvant générer de la chaleur en fonctionnement de ladite carte réseau 10.

Dans l'exemple décrit par rapport aux figures, la carte réseau 10 comprend deux composants électriques se présentant sous la forme de connecteurs 110A permettant de relier électriquement ladite carte réseau 10 d'une part à la carte mère de la lame de calcul et d'autre part à un lien ou un réseau de communication externe, par exemple via un commutateur.

Toujours dans l'exemple décrit par rapport aux figures, la carte réseau 10 comprend plusieurs composants électroniques 110B. Ces composants électroniques 110B peuvent être notamment de type microprocesseurs, puces ou condensateurs ou tout autre élément générant de la chaleur en fonctionnement de ladite carte réseau 10.

La carte réseau 10 se présente sous la forme d'un circuit électronique comprenant une face supérieure 10-1 sur laquelle sont montés les divers composants électriques et électroniques 110A, 110B et une face inférieure 10-2, comportant principalement les chemins électriques et les soudures des pattes des composants 110A, 110B.

### Dissipateur thermique 20

Le dissipateur thermique 20 est du type à refroidissement par conduction et comprend à cette fin, comme illustré sur les figures 1 à 4, un corps 210 qui est à la fois adapté pour collecter la chaleur de la carte réseau 10 et pour être fixé sur la plaque froide de la lame de calcul, dans laquelle circule le liquide réfrigérant, afin d'évacuer ladite chaleur par conduction vers ledit circuit de refroidissement.

Dans l'exemple illustré sur les figures, le dissipateur thermique 20 comprend en outre un élément de boîtier 220 permettant de protéger la carte réseau 10, comme cela sera décrit ci-après.

### Corps 210

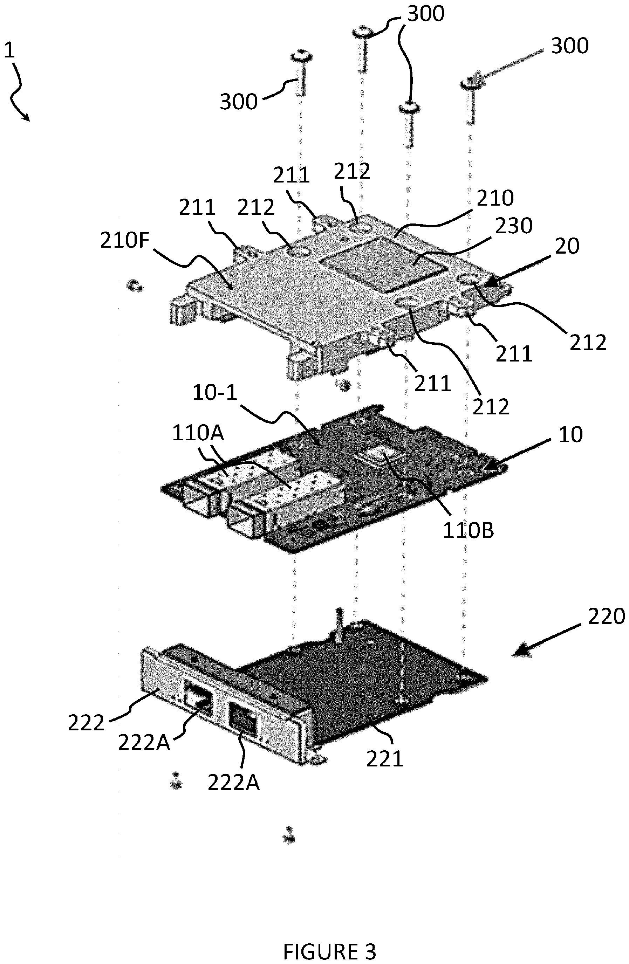

En référence aux figures 1 et 3, le corps 210 s'étend dans un plan principal α et comporte deux faces principales : une face dite « chaude » 210C (figure 1) et une face dite « froide » 210F (figure 3), opposée à ladite face chaude 210C.

Le corps 210 est réalisé en métal, de préférence en aluminium, de préférence encore en aluminium série 6063.

La face froide 210F du corps 210 est configurée pour s'interfacer avec la plaque froide. Par le terme « interfacer », il est entendu que la face froide 210F du corps 210 vient se placer contre la plaque froide pour lui transférer, par conduction, la chaleur collectée par la face chaude 210C dudit corps 210.

La face froide 210F présente avantageusement, dans l'exemple illustré sur les figures, une surface sensiblement plane sur laquelle est montée une interface de conduction de chaleur 230, visible sur la figure 3, afin d'améliorer la conduction de chaleur vers la plaque froide.

L'interface de conduction de chaleur 230 se présente sous la forme d'une portion plane métallique conductrice de chaleur, par exemple réalisée en aluminium, de préférence série 6063. Un matériau souple conducteur servant à transmettre la chaleur entre la plaque froide et l'interface de conduction de chaleur 230 de la carte réseau peut être utilisé, par exemple une pâte ou mousse conductrice à mémoire de forme.

La face chaude 210C est destinée à recevoir la face supérieure 10-1 de la carte réseau 10 pour collecter la chaleur générée par les composants 110A, 110B de ladite carte réseau 10. A cette fin, en référence à la figure 1, la face chaude 210C comprend des logements 210C-1 configurés pour recevoir les connecteurs 110A et les composants électroniques 110B générateurs de chaleur de la carte réseau 10.

La face chaude 210C est configurée de sorte que les composants 110A, 110B peuvent venir au contact d'une ou de plusieurs parois des logements 210C-1 et/ou être positionnés à une faible distance des parois des logements 210C-1, par exemple moins de 5 mm, pour absorber la chaleur générée par lesdits composants 110A, 110B.

Dans l'exemple illustré sur les figures, le corps 210 délimite quatre attaches 211, issues de matière du corps 210, configurée pour permettre la fixation du corps 210 sur la plaque froide à l'aide de vis (non représentées).

Le corps 210 délimite également quatre orifices de fixation traversants 212 reliant la face froide 210F à la face chaude 210C et configurés pour recevoir chacun une vis d'assemblage 300 permettant de fixer la carte réseau 10 sur ledit corps 210.

Le corps 210 délimite également deux orifices latéraux 214A permettant de recevoir deux vis simples 214B de fixation de l'élément de boîtier 220.

### Elément de boîtier 220

L'élément de boîtier 220 comprend une plaque de protection 221 et une façade de connexion 222.

La plaque de protection 221, de forme rectangulaire, est configurée pour recouvrir la face inférieure 10-2 de la carte réseau 10 afin de la protéger. La plaque de protection 221 peut par exemple se présenter sous la forme d'une tôle. La plaque de protection 221 peut par exemple être réalisée en acier.

La plaque de protection 221 délimite quatre orifices de fixation traversants 221A permettant de recevoir les vis d'assemblage 300 qui traversent à la fois dans cet exemple la plaque de protection 221, la carte réseau 10 et le corps 210 pour les solidariser entre eux. La plaque de protection 221 délimite également un orifice 221B permettant de recevoir une vis 221V permettant de fixer la plaque de protection 221 sur la carte réseau 10.

La façade de connexion 222 se présente dans cet exemple sous la forme d'un profilé en L fixé sur la plaque de protection 221, par exemple par soudage ou clipsage.

La façade de connexion 222 délimite deux ouvertures 222A rectangulaires permettant de recevoir les deux connecteurs 110A de la carte réseau 10.

### Exemple de fabrication

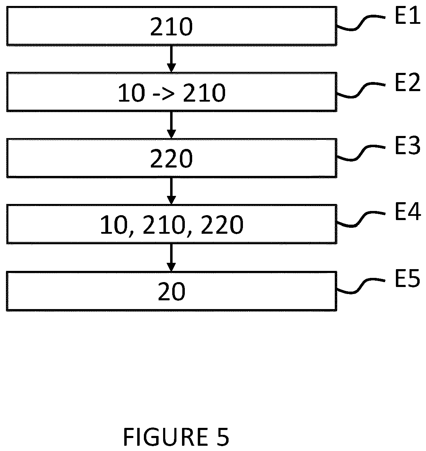

En référence à la figure 5, le corps 210 du dissipateur thermique 20 est fabriqué dans une première étape E1. La fabrication du dissipateur thermique 20 comprend la création du corps 210, par exemple par usinage dans de l'aluminium série 6063, notamment de la face chaude 210C et de la face froide 210F de sorte à former les logements 210C-1 permettant de recevoir les composants 110A, 110B générateurs de chaleur de la carte réseau 10.

Ensuite, dans une étape E2, la carte réseau 10 est placée sur le corps 210 de sorte que la face supérieure 10-1 de ladite carte réseau 10 soit montée en regard de la face chaude 210C du corps 210 du dissipateur thermique 20, les composants 110A, 110B s'étendant dans leurs logements 210C-1 respectifs de la face chaude 210C.

Dans une étape E3, l'élément de boîtier 220, notamment la plaque de protection 221, est placé sur la face inférieure 10-2 de la carte réseau 10 de sorte à la recouvrir et de sorte que les connecteurs 110A de la carte réseau 10 s'étendent à travers les ouvertures 222A de la façade de connexion 222.

L'élément de boîtier 220, la carte réseau 10 et le corps 210 sont ensuite solidarisés dans une étape E4, notamment à l'aide des vis d'assemblage 300.

Dans une étape E5, le dissipateur thermique 20 ainsi assemblé peut ensuite être monté sur la plaque froide de la lame de calcul à l'aide de vis et des attaches 211 de sorte que la face froide 210F soit interfacée avec une portion de la plaque froide.

L'invention présente ainsi l'avantage de pouvoir interfacer un unique dissipateur thermique avec plus de quatre ou cinq connecteurs, notamment avec seize connecteurs, tout en gardant une compacité, une efficacité et une solidité significatives.

## Revendications

1. Dissipateur thermique (20) pour une carte réseau (10) de lame de calcul, ladite lame de calcul comprenant une plaque froide dans laquelle circule un liquide réfrigérant, ledit dissipateur thermique (20) comprenant un corps (210) comportant deux faces principales dont une face dite « chaude » (210C) et une face dite « froide » (210F), opposée à ladite face chaude (210C), ladite face froide (210F) étant configurée pour être interfacée avec la plaque froide, la face chaude (210C) comprenant au moins un logement (210C-1) configuré pour recevoir au moins un composant (110A, 110B) générateur de chaleur de la carte réseau (10).

2. Dissipateur thermique (20) selon la revendication 1, comprenant une interface de conduction de chaleur (230) montée sur la face froide (210F) du corps (210).

3. Dissipateur thermique (20) selon la revendication précédente, dans lequel l'interface de conduction de chaleur (230) se présente sous la forme d'une plaque conductrice de chaleur, de préférence réalisée en un matériau souple conducteur de chaleur, par exemple de type pâte thermique ou mousse thermique.

4. Dissipateur thermique (20) selon l'une quelconque des revendications précédentes, ledit dissipateur thermique (20) comprenant un élément de boîtier (220) destiné à recouvrir la carte réseau (10).

5. Dissipateur thermique (20) selon la revendication précédente, dans lequel l'élément de boîtier (220) comprend une plaque de protection (221) configurée pour recouvrir la carte réseau (10).

6. Dissipateur thermique (20) selon la revendication précédente, dans lequel la plaque de protection (221) est réalisée en acier.

7. Dissipateur thermique (20) selon l'une quelconque des revendications 4 à 6, dans lequel l'élément de boîtier (220) comprend une façade de connexion (222), fixée à la plaque de protection (221), comprenant une portion s'étendant orthogonalement à la plaque de protection (221) et délimitant au moins un orifice de réception (222A) d'un connecteur (110A) de la carte réseau (10).

8. Dissipateur thermique (20) selon l'une quelconque des revendications précédentes, dans lequel le corps (210) délimite, au niveau de la face froide (210F), une pluralité d'attaches (211) configurées chacune pour recevoir une vis permettant de fixer le corps (211) sur la plaque froide.

9. Dissipateur thermique (20) selon l'une quelconque des revendications précédentes, dans lequel le corps (210) délimite une pluralité d'orifices de fixation (212) traversants, reliant la face chaude (210C) à la face froide (210F), configurés chacun pour recevoir une vis d'assemblage (300) permettant de solidariser à la fois le corps (210) et la carte réseau (10).

10. Dissipateur thermique (20) selon la revendication précédente, dans lequel, ledit dissipateur thermique (20) comprenant un élément de boîtier (220), ledit élément de boîtier (220) délimite une pluralité d'orifices de fixation traversants (221A), alignés avec les d'orifices de fixation traversants (212) du corps (210), configurés chacun pour recevoir une vis d'assemblage (300) permettant de solidariser à la fois l'élément de boîtier (220), le corps (210) et la carte réseau (10).

11. Module de dissipation thermique (1) comprenant une carte réseau (10) montée sur le corps (210) d'un dissipateur thermique (20) selon l'une quelconque des revendications précédentes.

12. Module de dissipation thermique (1) selon la revendication précédente, dans lequel, le dissipateur thermique (20) comprenant un élément de boîtier (220) solidaire au moins de la carte réseau (10), de préférence à la fois de la carte réseau (10) et du corps (210), la carte réseau (10) est montée entre l'élément de boîtier (220) et le corps (210).

13. Lame de calcul pour supercalculateur comprenant une plaque froide, à travers laquelle chemine un circuit de refroidissement liquide, et un module de dissipation thermique (20) selon l'une quelconque des revendications 11 ou 12 dont le corps (210) dudit au moins un dissipateur thermique (20) est fixé sur la plaque froide par l'intermédiaire de sa face froide (210F).

14. Procédé de fabrication d'un dissipateur thermique (20) pour une carte réseau (10) de lame de calcul, ledit procédé comprenant la création d'un corps (210) comportant une face dite « chaude » (210C) et une face dite « froide » (210F), opposée à ladite face chaude (210C), ladite face froide (210F) étant configurée pour être interfacée avec la plaque froide, la face chaude (210C) comprenant au moins un logement (210C-1) configuré pour recevoir au moins un composant (110A, 110B) générateur de chaleur de la carte réseau (10).

15. Procédé d'assemblage d'un module de dissipation thermique (1), ledit procédé comprenant le montage d'une carte réseau (10) sur le corps (210) d'un dissipateur thermique (20) selon l'une des revendications 1 à 10, la carte réseau (10) comprenant une face supérieure (10-1) comportant au moins un composant (110A, 110B) générateur de chaleur et une face inférieure (10-2), opposée à ladite face supérieure (10-1), le montage étant réalisé de sorte que la face supérieure (10-1) de la carte réseau (10) soient montée en regard de la face chaude (210C) du corps (210) du dissipateur thermique (20), l'au moins un composant (110A, 110B) s'étendant dans l'au moins un logement (210C-1) de la face chaude (210C).
